# EUROPEAN PATENT APPLICATION

(11) **EP 1 630 600 A2**
(43) Date of publication of application: **01.03.2006**
(21) Application number: 05254613.2
(22) Date of filing: 23.07.2005
(51) Int. Cl.: G03F 1/00, G03F 7/20, C09D 11/00

(54) **Hot melt composition and method involving forming a masking pattern**

(30) Priority: 29.07.2004 US 592260 P
(71) Applicant: Rohm and Haas Electronic Materials, L.L.C., Marlborough, Massachusetts 01752 (US)
(72) Inventor: Anzures, Edgardo, Westborough, Massachusetts 01581 (US); Barr, Robert K., Shrewsbury, Massachusetts 01545 (US)
(74) Representative: Kent, Venetia Katherine

(57) **Abstract**

A light-attenuating composition and method of using it are described. The light-attenuating composition may be selectively applied to a radiant energy sensitive material on the substrate. Actinic radiation applied to the composite chemically changes portions of the radiant energy sensitive material not covered by the light-attenuating composition. The light-attenuating composition attenuates light in at least the UV range and is water-soluble or water-dispersible.

## Description

### Background of the Invention

The present invention is directed to melts which selectively attenuate light at least within the UV range and methods of using the melts for imaging. More specifically, the present invention is directed to melts which selectively attenuate light at least within the UV range and are water-soluble or water-dispersible and methods of using the water-soluble or water-dispersible melts for imaging.

Methods of forming images on substrates encompass various industries such as the electronics, graphic arts and textile industries. Forming images typically involve lithography or photolithography. For example printed fabric labels may be made using a variety of techniques, such as screen printing, offset lithography printing, dyeing, flexographic printing, in-plant printing, and transfer printing. Such labels are suitable for garments for the purpose of decoration, identification, advertising, wash and care instructions, size, price, as well as other purposes.

Screen printing, also known as silk screen, employs a porous stencil mounted on a screen, in which the non-printing areas are protected by the stencil. The masking material also may be dried lacquer, shellac or glue. Printing is done on a mechanized press by feeding cloth under the screen, applying ink with a paint-like consistency to the screen, and spreading and forcing it through the fine mesh openings with a squeegee.

In offset lithography methods, the image and non-image areas are essentially on the same plane of the surface of a thin metal plate, the definition between them being maintained chemically. The ink is picked up by the hydrophobic areas on the plate but is not picked up by the hydrophilic areas. The image is then transferred to an offset rubber roll, then from the roll to the fabric sheet.

Flexographic printing is a form of rotary letterpress using flexible rubber plates and fast-drying fluid inks. The rubber plates utilize the relief method for image creation, where the image area is raised above the non-image areas. Ink rollers only touch the top surface of the raised area. The surrounding, non-printing, areas are lower and do not receive ink. The inked image is transferred directly to a cloth. Dyeing can be achieved by using dyestuffs rather than pigmented inks in any of the printing processes described above. The use of dyes, however, requires additional after treatments to fix the dye in the fabric.

In the electronics industry images are formed on substrates for the formation of circuitry by photolithography. This involves the use of a radiant energy sensitive material, such as photosensitive material, that is applied to a surface as a whole area coating (spin-casting, roller coating, spray and screen printing, and dipping) or as a whole area sheet (lamination). The material is applied in a light controlled laboratory in order to ensure that the photosensitive material is not pre-exposed prior to introducing the required pattern mask on top of the coated wafer or copper panels. The mask can be either a contact mask, a proximity mask or a projection mask. In all cases the mask is manufactured as a discrete unit to a high precision and is carefully protected against damage or dust/particulate collection. Once the mask is put in place then a lamp, of a radiation material matched to a photoinitiator used in the photosensitive material, may be used to expose the substrate coating in those areas not protected by the mask. Depending upon the photosensitive material type employed the pattern transfer achieved may be either positive or negative with respect to the mask. After exposure the photosensitive material is exposed to a developing chemical that modifies the chemistry of the coating in such a manner as to permit the untreated material to be washed away in a water-based dip bath or conveyor shower/spray.

Although spin-cast, dip, roller coating, spray and screen printing, or sheet lamination photolithographic methods of achieving a surface relief image are successful, they do have a number of problems such as material wastage (because of whole area technique), selective 3-D patterning is difficult and time consuming, chemistry used in photosensitive material has a high toxicity rating, disposability of large volumes of toxic and developing chemicals, and simple patterning is a multiple step process such as photocoating, mask alignment, radiation exposure, mask removal, pattern development, excess material rinse removal, and substrate drying.

One or more of these problems may be addressed by introducing further processes that can provide a patterned relief structure on a surface, including stenciling (screen printing), microdot transfer (stamping), and laser writing-etching (includes ablation scribing and direct-write photolithography equivalent imaging). Each technique has its merits and limitations which are driven by the detail of the intended application such as speed pattern generations, relief pattern thickness, controlled etch capability, cost of process and ease of use process. However, any one process does not address all of the problems cited above.

U.S. 5,779,779 discloses hot melt inks, which may block ultraviolet light and may be applied to substrates by inkjets for printing on the substrates. The patent discloses that the inks include ultraviolet blockers, plasticizers, dyes and waxes. The wax content of the inks may range from 30wt% to 95wt% of the ink. The patent discloses that the ink may be readily washed from silk screens using warm water, hot water or a solvent. However, the warm or hot water is functioning as a heat transfer agent, not as a solvent. In other words, the water carries heat to melt the ink as opposed to solubilizing it. Waxes such as Montan, paraffin and candelilla do not readily dissolve or disperse in water. Further many organic solvents are hazardous to both workers and the environment. Accordingly, the industry prefers to avoid or at least reduce their use.

Many methods used in the manufacture of electronic devices require selective application of a photosensitive material, which is then used to enable subsequent steps of the overall manufacturing process. For example, solder mask is excluded from through-holes in a printed wiring board but is present in other areas of the board which require resistance to solder applied later in the manufacturing process.

A variety of methods are currently practiced that enable the selective final presence of solder mask or other photosensitive material. For example, solder mask is patterned to fully cover electronic circuitry except for those portions intended to be exposed, e.g., for soldering to another component. Solder masks are typically formed from photosensitive material which is applied to a substrate such as a printed circuit board. The photosensitive material is exposed to actinic radiation, which is imaged by means of an artwork or phototool. Subsequent to exposure, the photosensitive material is developed in a solvent which washes away either exposed or unexposed portions of the material (depending upon whether the photosensitive material is positive-acting or negative-acting). The portion of the material which remains on the substrate is then cured, e.g., with heat or UV light to form a hard, permanent solder mask intended to protect the printed circuitry.

One problem in the electronics industry is proper alignment or registration such as in the manufacture of multi-layer printed wiring boards. Registration is the relative position of one or more printed wiring patterns or portions thereof with respect to desired locations on a printed wiring board or another pattern on the other side of the board. One of the challenges in the manufacture of multi-layer printed wiring boards is to obtain adequate innerlayer registration. Internal features must be registered accurately to each other, and they must be accurately registered to any drilled holes. Hole-to-innerlayer misregistration creates two potential reliability problems: failure of the hole to line connection and shorts between holes and isolated conductors. Misregistration of internal layers also increases electrical resistance and decreases conductivity. Severe misregitration creates an open-circuit condition, a complete loss of continuity.

One of the last steps in the manufacture of multi-layer printed wiring boards is the application of the solder mask onto an outside layer. As mentioned above the solder mask is selectively exposed using a phototool such that specific areas can be developed off of the board. Such phototools, typically composed of diazo, silver halide or quartz and chrome, are prepared based on "idealized" dimensions of circuit line placement. However, variations in actual board dimensions of the circuit line from the "idealized" dimensions are common because of rigorous processing employed in the manufacture of the boards. Using an "idealized" phototool in combination with dynamically changing boards often results in registration problems between boards in a multi-layer laminate. Because the solder mask step is one of the last steps in the manufacture of multi-layer printed wiring boards, discarded boards caused by misregistration lead to costly and inefficient manufacturing processes.

Further, in conventional practice workers often prepare multiple fixed phototools and manually try to find the optimum fit between phototool and board to avoid misregistration. Such a process is both inaccurate and time consuming resulting in further inefficiency of multi-layer printed wiring board manufacture.

In addition to providing accurate registration, workers desire a phototool which may be removed without damage to the photoresist. Many photoresists are sufficiently tacky such that when the phototool is removed the portions of the photoresist stick to it. This may result in damage to the pattern formed by the photoresist after exposure to actinic radiation and development. Also, workers desire phototools which selectively block-out undesired radiation. Many photoresists are sensitive to light at wavelengths up to 425nm. This covers both the UV and part of the visible light regions. Accordingly, the industry desires a phototool or mask which selectively blocks-out light in at least the UV light region, and may be removed from the photoresist without damage.

Accordingly, there is a need for improved compositions and methods of forming images on substrates.

### Summary of the Invention

Compositions include one or more compounds for attenuating light in at least the UV range, and one or more water-soluble or water-dispersible, film-forming polymers. The compositions are non-curable melts.

In another embodiment the compositions include one or more compounds for attenuating light in the UV and visible ranges, one or more water-soluble or water-dispersible, film-forming polymers, one or more antioxidants, and one or more acids or anhydrides thereof. Other components may be added to the compositions to tailor them to a desired performance.

Any compound which attenuates light in at least the UV range may be used in the compositions. Compounds which attenuate light in one of the UV and visible ranges also may be employed provided that at least one other light attenuating compound is added to the composition such that the composition attenuates both the UV and visible ranges. Accordingly, the compositions may be tailored to attenuate UV and visible light within discrete wavelengths of both regions.

Any suitable water-soluble or water-dispersible film-forming polymer may be used. Mixtures of the polymers also may be used in the compositions. Such polymers enable the compositions to be removed from a substrate with water or aqueous base in one minute or less. Such polymers are used to avoid undesirable organic solvents and developers to reduce the amount of potentially hazardous waste. Accordingly, the compositions are more environmentally friendly than many conventional melts.

In a further embodiment a method includes depositing a radiant energy sensitive composition or article on a substrate; selectively depositing a masking composition on the radiant energy sensitive composition or article to form a composite, the masking composition includes one or more compounds for attenuating light in at least the UV range, and one or more water-soluble or water-dispersible film-forming polymers; applying actinic radiation to the composite; and developing the composite to form a pattern on the substrate. The masking composition may be applied by any suitable method such as a digital method. Inkjetting is one such digital method.

The compositions are solids or semi-solids but are suitable for inkjetting since they are liquids at inkjetting temperatures. The compositions are inkjettable at low temperatures to reduce the chance of thermal degradation of the components of the compositions.

The compositions are readily removable from a substrate with water or aqueous base. Accordingly, organic developers may be avoided in imaging methods using the compositions, thus workers are not exposed to the hazardous organic developers used in many conventional imaging methods.

Further, registration problems, which are difficult to correct using many conventional techniques with conventional phototools, may be efficiently addressed by imaging methods using the masking compositions. Such registration problems are typically found in the manufacture of multi-layer printed wiring boards where the alignment of through-holes between adjacent boards is critical to the efficient manufacture and operation of the boards in electronic devices.

### Detailed Description of the Invention

As used throughout this specification, the following abbreviations have the following meanings, unless the context indicates otherwise: °C = degrees Centigrade; gm = grams; L = liters; mL = milliliters; wt% = percent by weight; cp = centipoise; kV = kilovolts; psi = pounds per square inch; mJ = milliJoules; cm = centimeters; UV = ultraviolet; and room temperature = 18°C to 25°C.

The terms "printed wiring board" and "printed circuit board" are used interchangeably throughout this specification. "Depositing" and "plating" are used interchangeably throughout this specification and include both electroless plating and electrolytic plating. "Multi-layer" refers to two or more layers. "Polymer" and "copolymer" are used interchangeably throughout the specification. A "polymer" is a compound having one or more repeating units. "Radiant energy" means energy from light or heat. "Actinic radiation" means radiation from light that produces a chemical change. "(Alkyl)acrylate" includes both "acrylates" and "alkylacrylates". "Viscosity = internal fluid friction or the ratio of the shear stress to the rate of shear of a fluid. "Pseudoviscosity" = viscosity of a thixotropic substance in its most viscous state. Acid number = grams of potassium hydroxide required to neutralize 1 gm of free acids, and to measure the free acids present in a substance. The terms "mask", "masking" and "attenuation" have the same meaning and are used interchangeably throughout the specification. A "dye" is a color former which is soluble in the inkjettable composition. A "pigment" is a color former which is insoluble in the inkjettable composition.

All percentages are by weight, unless otherwise noted and are based on dry weight or solvent free weight. All numerical ranges are inclusive and combinable in any order, except where it is logical that such numerical ranges are constrained to add up to 100%.

The compositions include one or more compounds for attenuating light in at least the UV range, and one or more water-soluble or water-dispersible film-forming polymers. The compositions are warm melts. The compositions may be employed as a mask in methods for forming an image on a substrate. The masking compositions may be selectively applied to a radiant energy sensitive material or article. For example, a photosensitive material may be applied to a substrate, such as in the formation of a printed wiring board. A masking composition may be selectively applied to the photosensitive material by any suitable method such as a digital method. If the photosensitive material is a dry film, the composition is applied to the cover sheet of the dry film article. Such cover sheets typically are made of polyethylene terephthalate (PET). Actinic radiation is applied to the composite, which includes the substrate, photosensitive material and the selectively applied mask composition. The light-attenuating compounds included in the masking composition absorb or reflect, i.e., block, sufficient actinic radiation from reaching the photosensitive material covered by the mask to prevent chemical alteration of the photosensitive material. The photosensitive material, which is not covered by the light-attenuating composition, is chemically altered. The light-attenuating composition is then removed with water or a suitable aqueous base solution. The light-attenuating compositions are not curable. Accordingly, the compositions do not include monomers with unsaturation.

Aqueous base solutions may be used to remove the photosensitive material, which was not exposed to the actinic radiation, or in the alternative, may remove the photosensitive material that was exposed to the actinic radiation. Typically negative-acting photosensitive material unexposed to actinic radiation is removed, and positive acting photosensitive material exposed to actinic radiation is removed. Examples of such photosensitive material include resists and inks. Resists include photoresists such as negative-acting and positive-acting photoresists, plating resists, etch or inner layer resists and solder masks. Such aqueous base solutions have pH ranges of 8 or higher, or such as from 8 to 12.

Any suitable light-attenuating compound may be used provided that it attenuates light in at least the UV range. Typically, such compounds attenuate light in the UV and visible ranges. Such compounds attenuate light at wavelengths of 800nm and below, or such as from 500nm to 300nm, or such as from 450nm to 350nm, or such as from 425nm to 400nm. Examples of light-attenuating compounds include absorbers, compounds typically used as photoinitiators and photosensitizers, and color formers such as pigments and dyes. Synthetic and natural dyes and pigments are included as well as compounds classified under "Pigment" in the color index (C.I.; published by The Society of Dyers and Colorists Company). Such compounds are included in the compositions in sufficient amounts such that the compositions attenuate at least UV light within the desired wavelength range. Generally, the light-attenuating compounds are included in amounts such as from 0.1wt% to 50wt%, or such as from 1wt% to 30wt%, or such as from 5wt% to 15wt% of the composition.

If a light-attenuating compound attenuates in only the UV range or the visible range, it may be combined with one or more other compounds such that the composition attenuates light in both the UV and visible ranges. Compounds may be combined to tailor the compositions to attenuate both UV and visible light within discrete wavelength ranges. The wavelengths at which a compound attenuates light may readily be determined using conventional UV/visible spectrophotometry.

Compounds which absorb light and are suitable for the masking compositions include, but are not limited to, thioxanthone and substituted thioxanthones, benzophenone and substituted benzophenones, benzotriazole and substituted benzotriazoles, and triazines and substituted triazines. Such compounds are used in amount of from 0.1wt% to 30wt%, or such as from 0.5wt% to 20wt%, or such as from 0.75wt% to 10wt%, or such as from 1wt% to 5wt% of the composition. The light-absorbing compounds may be made according to methods disclosed in the literature. Some are commercially available.

Thioxanthone and the substituted thioxanthones have a general formula: 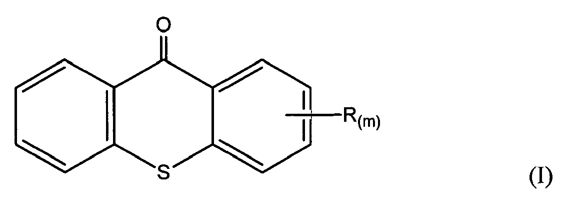
where R is independently hydrogen, halogen, hydroxyl, acetyl, linear or branched (C₁-C₂₀)alkyl, (C₆-C₁₀)aryl, (C₇-C₂₄)alkylaryl, and linear or branched (C₁-C₂₀)alkoxy, and m is an integer from 1 to 4. Halogens include fluorine, bromine, chlorine and iodine. Typically the halogen is bromine and chlorine. Most typically the halogen is chlorine. Examples of such compounds are thioxanthone, 2-isopropyl thioxanthone, 4-isopropyl thioxanthone, 2,4-diethyl thioxanthone, 2-chlorothioxanthone, 1-chloro-4-propoxythioxanthone, 2-bromothioxanthone, 2-methyl thioxanthone, 2-phenyl thioxanthone, 2-benzyl thioxanthone, 2-acetyl thioxanthone, 1-chloro-4-hydroxy thioxanthone, 1-chloro-4-n-propoxy thioxanthone, 1,3-dichloro-4-n-propoxy thioxnathone, 4-benzyloxy-1-chlorothioxanthone, 1-chloro-3-methyl-4-n-propoxy thioxanthone, 1-fluoro-4-n-propoxy thioxanthone, 3-chloro-2-n-propoxy thioxanthone, 1-chloro-4-octyloxy thioxanthone, 1-chloro-2-methyl-4-n-propoxy thioxanthone, 1-bromo-4-propoxy thioxanthone, 1,4-dimethoxy thioxanthone, and 1-chloro-4-isopropoxy thioxanthone.

Benzophenone and substituted bezophenones include, but are not limited to, compounds having the following formula: 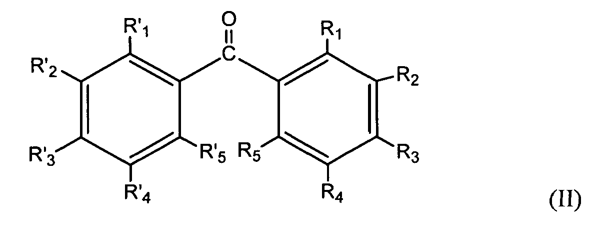 where R₁ to R₄ are independently hydrogen, hydroxyl, halogen, (C₁-C₂₀)alkoxy, (C₁-C₂₀)hydroxy alkyl, (C₁-C₂₀)alkyl, phenoxy, -C(R₆)₃ where R₆ is independently hydrogen and halogen, -N(R₇R₈) where R₇ and R₈ are independently hydrogen, linear or branched (C₁-C₅)alkyl, R₅ is hydrogen, R₁' to R₄' are the same as R₁ to R₄, and R₅' is the same as R₅. Halogens include fluorine, bromine chlorine and iodine. Examples of such compounds are 4-(dimethylamino)benzophenone, 4,4'-bis(dimethylamino)benzophenone, 4,4'-bis(diethylamino)benzophenone, 4,4'-(methyethylamino)benzophenone, 2,2'-dihydroxy-4-methoxybenzophenone, and 4,4'-bis(diphenoxy)benzophenone.

Examples of suitable substituted benzotriazoles are 2-(2-hydroxy-5-methylphenyl)-2H-benzotriazole, 2-(2-hydroxy-3,5-di-tert-amylphenyl)-2H-benzotriazole, 2-(2-hydroxy-5-tert-octylphenyl)-2H-benzotriazole, 5-chloro-2-(2-hydroxy-3,5-di-tert-butylphenyl)-2H-benzotriazole, 5-chloro-2-(2-hydroxy-3-tert-butyl-5-methylphenyl)-2H-benzotriazole, 2-(2-hydroxy-3,5-di-tert-butylphenyl)-2H-benzotriazole, 2-(2-hydroxy-5-methylphenyl)-2H-benzotriazole, 2-(2-hydroxy-5-methyl)-2H-benzotriazole and 2-(2-hydroxy-3,5-di-tert-amylphenyl)-2H-benzotriazole.

Examples of suitable substituted triazines are 1,3,5-triazines having the following formula: 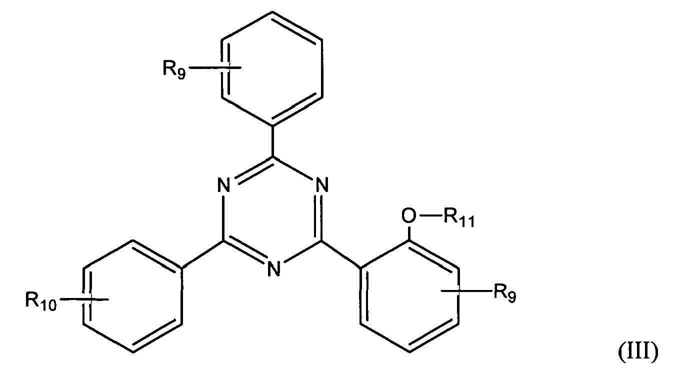 where R₉ and R₁₀ are independently hydrogen, halogen such as chlorine, bromine and iodine, -CN, (C₁-C₁₈)alkyl, and (C₁-C₁₈)alkoxy, and R₁ is (C₁-C₁₈)alkyl. (C₁-C₁₈)alkyl and (C₁₋C₁₈)alkoxy are respectively straight-chain and branched alkyl and alkoxy groups such as methyl, ethyl, n-propyl, isopropyl, n-butyl, sec-butyl, tert-butyl, amyl, isoamyl or tert-amyl, heptyl, octyl, isooctyl, nonyl, undecyl, dodecyl, tetradecyl, pentadecyl, hexadecyl, heptadecyl or octadecyl, and methoxy, ethoxy, proipoxy, butoxy, pentyloxy, hexyloxy, heptyloxy, octyloxy, isooctyloxy, nonyloxy, undecyloxy, dodecyloxy, tetradecyloxy, pentadecyloxy, hexadecyloxy, heptadecyloxy, and octadecyloxy.

Examples of other suitable substituted triazines are tris-substituted 1,3,5-triazines, phenylamino-1,3,5-triazines, s-triazines, halomethyl-1,3,5-triazines, symmetrically and asymmetrically substituted triazines.

Examples of suitable color formers include, but are not limited to, iron oxides such as iron (III) oxide, zinc oxides, chromium oxides, cobalt oxides, cadmium red, barium sulfate, ultramarine blues (aluminosilicates), mixed phase titanates such as C.I. Pigment Green-Yellow PY-53, C.I. Pigment Yellow PY-53, and C.I. Pigment Red-Yellow PBr-24, mixed phase metal oxides such as C.I. Pigment Yellow PY-119, C.I. Pigment Brown PBr-29, and C.I. Pigment Brown PBr-31, titanium dioxides such as rutile and anatase, amber, and lead chromates.

Examples of other suitable color formers include, but are not limited to, carbon black, indigo, phthalocyanine, para red, flavanoids such as red, yellow, blue, orange and ivory colors.

Examples of additional suitable color formers include, but are not limited to, azo dyes, anthraquinone, benzodifuranone, indigold, methine and related dyes, styryl, di- and triaryl carbonium dyes and related dyes, quinophthalones, sulfur-based dyes, nitro and nitroso dyes, stilbenes, formazans, dioxazines, perylenes, quinacridones, pyrrolo-pyrroles, isoindolines, anthraquinoid, perinone, xanthene, quinoline, pyrazolone, and isoindolinones.

Examples of pigments having color index (C.I.) numbers include C.I. Pigment Yellow 12, C.I. Pigment Yellow 13, C.I. Pigment yellow 14, C.I. Pigment Yellow 17, C.I. Pigment Yellow 20, C.I. Pigment Yellow 24, C.I. Pigment Yellow 31, C.I. Pigment Yellow 55, C.I. Pigment Yellow 83, C.I. Pigment Yellow 93, C.I. Pigment yellow 109, C.I. Pigment Yellow 110, C.I. Pigment Yellow 139, C.I. Pigment Yellow 153, C.I. Pigment Yellow 154, C.I. Pigment Yellow 166, C.I. Pigment Yellow 168, C.I. Pigment Orange 36, C.I. Pigment Orange 43, C.I. Pigment Orange 51, C.I. Pigment Red 9, C.I. Pigment Red 97, C.I. Pigment Red 122, C.I. Pigment Red 123, C.I. Pigment Red 149, C.I. Pigment Red 176, C.I. Pigment Red 177, C.I. Pigment Red 180, C.I. Pigment Red 215, C.I. Pigment Violet 19, C.I. Pigment Violet 23, C.I. Pigment Violet 29, C.I. Pigment Blue 15, C.I. Pigment Blue 15:3, C.I. Pigment Blue 15:6, C.I. Pigment Green 7, C.I. Pigment Green 36, C.I. Pigment Brown 23, C.I. Pigment Brown 25, C.I. Pigment Black 1 and C.I. Pigment Black 7.

To provide water-solubility or water-dispersibility the light-attenuating compositions include one or more water-soluble or water-dispersible polymers. Suitable polymers are polymers having alkoxylated backbones. Such polymers enable the compositions to be removed from a substrate with water or aqueous base in a period of one minute or less, or such as from 5 seconds to one minute, or such as from 10 seconds to 30 seconds.

Examples of such water-soluble or water-dispersible polymers include polymers having a general formula:

R₁₂-R₁₃-(OR₁₃)ₙ(OR₁₆)ₚ(OR₁₇)_{q}-R₁₄ (IV)

where R₁₃ is a linear or branched (̵C₁-C₁₀)̵aliphatic, typically R₁₃ is a linear or branched (̵C₂₋C₃)̵aliphatic; R₁₂ and R₁₄ are independently hydroxyl, substituted or unsubstituted (C₁₋C₂₀)alkoxy, substituted or unsubstituted (C₆-C₁₀)aryloxy, carboxyl, sulfonic, phosphonic or salts thereof, and primary or secondary amino groups; R₁₆ and R₁₇ are independently a linear or branched (̵C₁-C₁₀)̵aliphatic; n is an integer of from 1 to 100, typically from 5 to 50, more typically from 10 to 20; p is an integer of 0 to 100, typically from 5 to 50, more typically of 10 to 20; and q is an integer of from 0 to 100, typically of 5 to 50, more typically of 10 to 20. When q=0, R₁₄ is bonded to a carbon of R₁₇. When p=0, a carbon of (OR₁₃)ₙ is bonded to an oxygen of (OR₁₇)_{q}. When p and q=0, R₁₄ is bonded to a carbon of (OR₁₃)ₙ.

Examples of additional suitable water-soluble or water-dispersible polymers include polymers having a general formula:

R₁₈-(OR₁₉)ₙ(OR₂₀)ₚ(OR₂₁)_{q}-R₂₂ (V)

where R₁₈ is a linear or branched (C₁-C₁₀₀)alkyl and substituted or unsubstituted (C₆-C₁₀)aryl; R₂₂ is hydroxyl, substituted or unsubstituted (C₁-C₂₀)alkoxy, substituted or unsubstituted (C₆₋C₁₀)aryloxy, carboxyl, sulfonic, phosphonic or salts thereof, and primary or secondary amino group; R₁₉, R₂₀ and R₂₁ are independently linear or branched (̵C₁-C₁₀)̵aliphatic, typically (̵C₂₋C₃)̵aliphatic; and n, p and q are defined as above. When q=0, R₂₂ is bonded to a carbon of R₂₀. When p=0, a carbon of R₁₉ is bonded to an oxygen of (OR₂₁)_{q}. When p and q=0, R₂₂ is bonded to a carbon of R₁₉.

Substituents include halogens such as fluorine, bromine, chlorine and iodine, hydroxyl, (C₁-C₁₀)hydroxyl alkyl, (C₁-C₁₀)alkyl, (C₆-C₁₀)aromatic, (C₁-C₁₀)alkoxy, (C₆-C₁₀)aryloxy, (C₆₋C₁₂)alkylaryl, carboxyl, sulfonic, phosphonic and salts thereof, and -N(R₂₃R₂₄) where R₂₃ and R₂₄ are independently hydrogen, and (C₁-C₁₀)alkyl. The weight-average molecular weight of such polymers ranges from 200 to 6000, or such as from 500 to 5000, or such as from 800 to 4000, or such as from 900 to 2000. Molecular weights may be determined by gel-permeation chromatography (GPC).

Such polymers include polyalkoxylates such as polyethylene glycols, methoxypolyalkoxylates such as methoxypolyethylene glycols, polyalkoxylated polyalkanes such as polyethylene-co-polyethylene glycols, substituted aryloxyalkoxylates such as tristyrylphenol ethoxylate, and polyetheramines also known as polyoxyalkylene amines. Such compounds may be made by methods disclosed in the literature. Some are commercially available such as the polyethylene glycols which are available from Union Carbide under the tradename CARBOWAX™ 1000 and CARBOWAX™ 1450. Methoxpolyethylene glycols are available from Union Carbide under the tradename CARBOWAX™ 2000. Other polymers which are commercially available are the polyethylene-co-polyethyelene glycols obtainable from Baker Petrolite under the tradename UNITHOX™ 380, UNITHOX™ 450 and UNITHOX™ 720. The polyethylene glycols are typically composed of 100wt% of ethylene oxide repeating units, and the polyethylene-co-polyethylene gycols typically compose from 20wt% to 80wt%, or such as from 30wt% to 60wt% ethylene oxide units. Examples of commercially available polyetheramines are the JEFFAMINE® product family available from Huntsman Corporation (Houston, Texas). The polyether backbone is based either on propylene oxide (PO), ethylene oxide (EO), or mixed EO/PO. The JEFFAMINE® product family includes monoamines, diamines, and triamines, which are available in a variety of molecular weights ranging up to 5000. Specific examples of such commercially available polyetheramines are JEFFAMINE® M-2070, JEFFAMINE® EDR-148, JEFFAMINE® D-230, D-400, and D-2000, and JEFFAMINE® T-403 and T-5000.

Water-soluble and water-dispersible polymers derived from polymers IV and V also are suitable. Examples of such derivatives are urethanes, esters, amides, ureas, and amino alcohols. Hydroxyl functionalities in structures IV and V may be reacted with isocyanates to form urethanes. Esters may be formed by reacting the hydroxyl functionalities with carboxylic acids, or in the alternative, carboxylic acid functionalities on polymers IV and V may be reacted with hydroxyl group containing compounds. Amides may be formed by reacting amino functionalities with carboxylic acid groups or carboxylic acids functionalities with isocyanates or amines. Ureas may be formed by reacting amino functionalities with isocyanates. Amino alcohols may be formed by reacting amino functionalities with epoxies. Such reaction process are well known in the art.

The polymers compose from 60wt% to 99wt%, or such as from 70wt% to 95wt%, or such as from 75wt% to 90wt% of the compositions. Mixtures of the polymers described above may be used.

Optional components such as antioxidants, organic acids and their anhydrides may be included in the masking compositions.

Examples of suitable antioxidants include phenolics including hindered phenols, phosphites, lactones, alkylated monophenols, alkylthiomethylphenols, hydroquinones, tocopherols, hydroxylated thiodiphenyl ethers, alkylidenebisphenols, O-, N- and S-benzyl compounds, hydroxybenzylated malonates, aromatic hydroxybenzyl compounds, benzylphosphonates, aminic antioxidants such as hindered amines, and ascorbic acid. Such compounds are well known in the art and many may be obtained commercially such as the hindered phenols under the tradename IRGANOX™ obtainable from Ciba Specialty Chemicals. An example is IRGANOX™ 1076 (octadecyl-3,5-di-t-butyl-4-hydroxyhydrocinnamate). One or more may be used in the compositions. Such antioxidants are included in amounts of 0.01 wt% to 10wt%, or such as from 0.5wt% to 5wt% of the composition.

Examples of suitable acids and anhydrides include octanoic acid, oxalic acid, malonic acid, tartaric acid, citric acid, benzoic acid, phthalic acid, glycolic acid, malic acid, oxalic acid, succinic acid, glutaric acid, lactic acid, salicylic acid, sebacic acid, benzenetricarboxylic acid, cyclohexane carboxylic acid, and phthalic anhydride. One or more of such acids and anhydrides may be used in amounts of from 0.1 wt% to 15wt%, or such as from 1wt% to 10wt%, or such as from 3wt% to 8wt% of the composition.

In addition to the antioxidants and organic acids, other optional components may include, but are not limited to, surfactants, buffers, biocides, fungicides, bactericides, and viscosity modifiers. Such optional components are well known in the art and are used in conventional amounts.

The light-attenuating compositions may be prepared by any suitable method known in the art. One method is to form a solution, suspension or dispersion of the components. The polymers which compose the compositions typically are liquids, solids or semi-solids at room temperatures. Solids and semi-solids may be heated to soften or liquefy them such that they may be readily mixed with the other components. Components may be combined in any order in a suitable mixing or homogenizing apparatus. Sufficient heat may be applied when needed to solubilize or mix any of the components to form a homogeneous mixture. Temperatures of above 25° C to 150° C typically are employed to mix the components. After the components are uniformly mixed the mixture may be cooled to 25° C or below to form a solid or semi-solid melt.

The light-attenuating compositions may be selectively applied to a radiant energy sensitive material or radiant energy sensitive article such as a dry film article by any suitable means. An example of a suitable application method includes, but is not limited to, inkjetting. Examples of radiant energy sensitive material include, but are not limited to, resists and inks. Resists include photosensitive materials such as photoresists, and plating resists.

Any suitable inkjet apparatus may be employed to selectively apply light-attenuating compositions to a radiant energy sensitive material. Inkjet apparatus may digitally store information in its memory for a selective mask design to be applied to the radiant energy sensitive material, thus the light-attenuating compositions may be selectively and directly applied to the radiant energy sensitive material without intervening steps. Examples of suitable computer programs are standard CAD (computer aided design) programs for generation of tooling data. Workers may readily modify the selective deposition of the light-attenuating compositions by changing the program digitally stored in the inkjet apparatus. Additionally, registration problems also may be readily addressed. The inkjet apparatus may be programmed to perceive potential incorrect alignment between substrates, such as in the manufacture of multi-layer printed wiring boards. When the apparatus senses misregistration between boards, the program modifies the inkjet application of the mask pattern to avoid or correct misregistration between adjacent boards. The ability to re-design the mask pattern from board to board reduces the potential for misregistration between the boards, and eliminates the costly and inefficient task of preparing multiple fixed phototools. Accordingly, efficiency of selective deposition of the mask and image formation is improved over many conventional methods.

There are two major categories of inkjet printing, "Drop-On-Demand" inkjet and "Continuous" inkjet. Using Drop-On-Demand inkjet technology the light-attenuating composition is stored in a reservoir and delivered to a nozzle in the print head of the printer. A means exists to force a single drop of light-attenuating composition out of the nozzle and onto a radiant energy sensitive material. Typically this is a piezo electric actuation of a diaphragm within a chamber, which "pumps" the droplets out of the nozzles, or a localized heating of the fluid to increase the pressure within the chamber, thus forcing a droplet to jet. Prior to passing out of the nozzle, the pressurized light-attenuating composition stream proceeds through a ceramic crystal, which is subjected to an electric current. This current causes a piezoelectric vibration equal to the frequency of AC (alternating current) electric current. This vibration, in turn, generates droplets of the composition from the unbroken stream. The composition breaks up into a continuous series of drops, which are equally spaced and of equal size. Surrounding the jet at the point where the drops separate from the liquid stream in a charge electrode a voltage is applied between the charge electrode and the drop stream. When the drops break off from the stream, each drop carries a charge proportional to the applied voltage at the instant at which it breaks off. By varying the charge electrode voltages at the same rate as drops are produced every drop may be charged to a predetermined level. The drop stream continues its flight and passes between two deflector plates, which are maintained at a constant potential such as +/- 0.1 kV to +/- 5 KV, or such as +/- 1 kV to +/- 3 kV. In the presence of this field, a drop is deflected towards one of the plates by an amount proportional to the charge carried. Drops, which are uncharged, are undeflected and collected into a gutter to be recycled to the ink nozzle. Drops, which are charged and hence deflected, impinge on a radiant energy sensitive material traveling at right angles to the direction of drop deflection. By varying the charge on individual drops, a desired pattern can be applied. Drop sizes may range from 30 µm to 100 µm, or such as from 40 µm to 80 µm, or such as from 50 µm to 70 µm in diameter.

The inkjet processes are adaptable to computer control for high-speed application of continuously variable data. Inkjet printing methods may be divided into three general categories: high pressure (10 psi and greater), low pressure (less than 10 psi) and vacuum techniques. All are known in the art or described in the literature and can be employed in the application of the light-attenuating composition to radiant energy sensitive materials.

Light-attenuating compositions are applied from an inkjet at viscosities of from 5 cp to 25 cp, or such as from 5 cp to 20 cp or such as from 10 cp to 15 cp at temperatures greater 25° C, or such as 50° C to 250° C, or such as from 100° C to 150° C. Pseudoviscosities of the light-blocking compositions are 10,000 cp or greater, or such as from 20,000 cp to 100,000 cp, or such as from 30,000 cp to 70,000 cp at temperatures of 25° C or less, or such as 15° C to 23° C. Such pseudoviscosities are after the light-attenuating compositions cool to room temperature.

The polymers and amounts of such polymers described above also contribute to the formation of the desired viscosities and pseudoviscosities. The optional components described above also are employed to achieve the desired viscosities and pseudoviscosities. The light-attenuating compositions are thin (5 cp to 25 cp) at the nozzle of an inkjet apparatus and are thickened (10,000 cp or greater) after application on a substrate.

After the mask is removed along with any portions of radiant energy sensitive material, a pattern is left on the substrate. The patterned substrate may be further processed or the patterned substrate may be the completed article. In the case of solder mask, the portions of the material left on the substrate are cured by UV light or UV thermal radiation. Conventional methods may be used.

Substrates employed in electronic articles may be further processed by depositing one or more metal layers in the spaces and channels formed by the pattern. Metal or metal alloys may be deposited electrolessly, electrolytically, or by immersion. Any suitable electroless, electrolytic, and immersion bath and method may be employed to deposit metal or metal alloy layers. Many such baths are commercially available or may be readily made from the literature. Also many methods are known in the art and from the literature. Metals, which may be deposited include, but are not limited to, noble and non-noble metals and their alloys. Examples of suitable noble metals include, gold, silver, platinum, palladium and their alloys. Examples of suitable non-noble metals include, copper, nickel, cobalt, lead, iron, bismuth, zinc, ruthenium, rhodium, rubidium, indium, and their alloys.

Substrates containing metal or metal alloy deposits may be joined together, such as by lamination, to form multi-layer printed circuit boards. Various lamination processes are known in the art or described in the literature. One problem associated with the manufacture of multi-layer printed wiring boards is registration as mentioned above. Registration is the relative position of one or more printed wiring patterns or portions thereof with respect to desired locations on a printed wiring boards or another pattern on the other side of the board. One of the challenges in the manufacture of multi-layer printed wiring boards is to obtain adequate innerlayer registration. Internal features must be registered accurately to each other, and they must be accurately registered to any drilled holes. Hole-to-innerlayer misregistration creates two potential reliability problems: failure of the hole to line connection and shorts between holes and isolated conductors. Misregistration of internal layers also increases electrical resistance and decreases conductivity. Severe misregistration creates an open-circuit condition, a complete loss of continuity.

Methods of the present invention address the misregistration problem. For example application of the light-attenuating compositions by inkjet permits accurate deposition of the compositions at selective points on radiant energy sensitive material on a substrate. Such selective deposition may be repeated with reliable accuracy for multiple substrates because inkjets may be digitally programmed for accurate repetitive application. Additionally, such programs may correct for misregistration problems by sensing misalignment and redesigning mask patterns to prevent misregistration between adjacent substrates.

In an exemplary embodiment light-attenuating compositions may be selectively deposited on photoresist or on a cover sheet of a dry film photoresist in the formation of a solder mask on a substrate such as a printed circuit board. Solder mask is a hard permanent layer of nonconductive material, which covers the surface of a printed circuit board encapsulating circuit traces of the printed circuit. The light-attenuating compositions may be selectively applied to photoresists on printed circuit board such that the mask outlines a pattern such that the solder mask covers the circuit traces in the final article. Selective application of the light-attenuating compositions may be done by inkjetting.

Positive-acting and negative-acting photoresists may be employed as well as liquid and dry-film. For example, if the light-attenuating composition is applied as a mask to a negative-acting photoresist, both the mask and the photoresist may be removed after exposure to actinic radiation with an aqueous base. If the light-attenuating composition is applied as a mask to a positive-acting photoresist, both the mask and the exposed photoresist may be removed with an aqueous base. The portions of the photoresist, which remain on the substrate, may be cured using conventional methods, and the substrates may optionally be further processed according to known methods in the industry.

The light-attenuating compositions and methods of mask formation may be practiced on any suitable radiant energy sensitive material. Typically such materials are coated or laminated on a substrate prior to mask formation. Examples of suitable substrates include, but are not limited to, metals, and dielectrics such as ceramics, glass, plastics, epoxy/fiberglass materials as in FR4 printed wiring boards.

The following examples are intended to further illustrate the invention and are not intended to limit its scope.

### Example 1

### Inkjettable Compositions

The table below discloses seven examples of inkjettable compositions.

| **Formulation** | **1** | **2** | **3** | **4** | **5** | **6** | **7** |
|---|---|---|---|---|---|---|---|
| **Polymers** | | | | | | | |
| Polyethylene glycol MW = 950-1050 | 94.5wt% | | 56.7wt% | | 66.15wt% | 56.7wt% | 54wt% |
| Polyethylene glycol, MW =1305-1595 | | | | | | | |
| Polyethylene-co-polyethylene glycol, MW =1750 | | | 37.8wt% | 37.8wt% | | 37.8wt% | 36wt% |
| Polyethylene-co- polyethylene glycol, MW =920 | | 94.5wt% | | 56.7wt% | | | |
| Polyethytlene-co-polyethytlene glycol, MW =875 | | | | | 28.35wt% | | |
| **UV/Visible Absorbers** | | | | | | | |
| 2-isopropylthioxanthone + 4-isopropylthioxanthone | 5wt% | 5wt% | 5wt% | 5wt% | 5wt% | | 4.762wt% |
| 4,4'-bis(diethylamino)benzophenone | | | | | | 5wt% | |
| **Antioxidants** | | | | | | | |
| Octadecyl 3,5-di-t-butyl-4-hydroxyhydrocinnamate | 0.5wt% | 0.5wt% | 0.5wt% | 0.5wt% | 0.5wt% | 0.5wt% | 0.476wt% |
| **Acid/Anhydride** | | | | | | | |
| Glycolic acid | | | | | | | 4.762wt% |
| **Viscosity (centipoise)** | | | | | | | |
| 110°C | | | | | 14.2 | | |
| 120°C | 19.3 | 12.1 | 18.4 | 18.2 | 12.9 | 19.1 | 22 |
| 130°C | | | | | 10.9 | | |

All seven formulations were prepared by the same method. The polymers were first melted to form a liquid or a viscous semi-solid. The remaining components were added to the liquefied or viscous semi-solid and mixed to form a homogenous composition. Each composition was then cooled to room temperature to form solids.

The viscosity of each formulation was measured at 110°C, 120°C or 130°C. The viscosity was measured using a Brookfield viscometer and thermosel attachment. All of the viscosities were below 25 centipoise as shown in the table above. The formulations were suitable for inkjetting using a conventional inkjet apparatus.

### Example 2

### Inkjetting a Formulation

Formulation 5 from the table in Example 1 was inkjetted from a piezoelectric drop-on-demand printhead (Spectra Apollo) onto copper panels with soldermasks. The temperature during inkjetting was 125°C. Drops of an average of 35 nanograms exited the printhead at an average velocity of 6.5 m/s. The velocity was measured with a conventional drop watcher. Formulation 5 was suitable for use with a conventional drop-on-demand inkjetting apparatus.

### Example 3

### Light-Attenuating

An acrylic/epoxy soldermask having the formulation:

| **Component** | **% Wt.** |
|---|---|
| Tris(2-hydroxyethyl) isocyanurate triacrylate | |
| Methylated melamine | 18.7 |
| Hetron 912 (epoxy methacrylate resin) | 3.4 |
| Novacure 3701 (diacrylate ester of a bisphenol A epoxy resin) | 6.2 |
| Epoxy cresol novolac resin, epoxy eq. 235 | 23.8 |
| Bisphenol A epoxy resin, epoxy eq. 575-685 | 23.3 |
| 5-(2,5-dioxotetrahydrofuryl)-3-methyl-3-cyclohexene-1,2-dicarboxylic anhydride | 8.6 |
| 2,2-dimethoxy-2-phenyl acetophenone | 1.4 |
| 2-methyl-1-[4-(methylthio)phenyl]-2-(4-morpholinyl)-1-propanone | 6.2 |
| isopropylthioxanthone | 2.3 |
| | 100.0 |

| PLUS Additives: | |
|---|---|
| Modaflow | 0.9 |
| Byk 361, 306 (equal portions) | 0.8 |
| Pigment (Penn Green) | 1.0 |
| Filler (Cabosil EH5, fumed silica) | 1.5 |
| Inhibitor (MEHQ) | 0.1 |
| Solvent (Amount and type appropriate to the method of application) | |
| Solvent used: Ethyl-3-ethoxy propionate (EEP) | |

was deposited on each of 10 mechanically-scrubbed copper panels and then dried at 77°C for 40 minutes until the soldermask on each panel was tack-free. A masking composition having the components of formulation 3 from Example 1 was selectively applied to each soldermask using a piezoelectric drop-on-demand printhead (Spectra Apollo) at 120°C. The composites of the copper panel, soldermask and masking composition were exposed to a broadband UV/visible light source (xenon mercury lamp). Light at wavelengths of 425nm and below was attenuated at portions of the soldermasks covered by the masking compositions.

Each panel was developed using a 1wt% aqueous potassium and sodium carbonate solution at 30°C such that the masking composition and the soldermask under the masking composition were removed. The exposed soldermask was at a clear copper 12 step (21 step wedge) showing proper degree of cure.

### Example 4

### Li ght-Attenuating

The same procedure as in Example 3 was performed with formulation 6 from Example 1. The masking composition attenuated light from the broadband UV/visible light source at wavelengths of 425nm and below to prevent the soldermask which it covered from undergoing a chemical change to form an alkaline resistant soldermask. Upon developing with 1wt% aqueous sodium carbonate, the masking composition and the soldermask coated with the masking composition were removed. The soldermask exposed to the UV/visible light was at a clear copper 12 step (21 step wedge).

### Example 5

### Developing Time

10 copper panels were mechanically scrubbed. 2 lines of black, water-soluble ink (from Sanford) 1cm wide and 5cm long were placed on each panel. The ink was dried at room temperature. A masking composition having formulation 3 in Example 1 was deposited on the ink lines on each panel to a thickness of 50microns using a piezoelectric drop-on-demand-inkjet head. The masking composition was deposited at a temperature of 125°C.

After the masking composition dried on each panel, the panels were developed using 1wt% aqueous sodium carbonate at 30°C. The development time was determined as the time that it took to remove the masking composition as indicated visually by removal of the ink underneath the masking composition. A stop watch was used to time the development. The average developing time was 7 seconds. The short development time minimized the time that the photoresist was exposed to developer. This in turn reduced the time that the developer may attack the cured resist.

### Example 6

### Developing Time

The same procedure as describe in Example 5 was performed using formulation 7 in Example 1. The average developing time was 3 seconds. The masking composition showed a further improved developing time.

### Example 7

### Inkjettable Composition

The formulation in the table below is prepared by the same process as the compositions described in Example 1.

| **Component** | **Amount Wt.%** |
|---|---|
| Polyethylene glycol (MW = 950-1050) | 57 |
| Polyethylene-co-polyethylene glycol MW = 1750 | 37.5 |
| Methine dye | 2.5 |
| 2-isopropylthioxanthone + 4-isopropylthioxanthone | 2.5 |
| Octadecyl-3,5-di-t-butyl-4-hydroxyhydrocinnamate | 0.5 |

The composition attenuates light from 425nm and below. The viscosity is measured using a Brookfield viscometer with a thermosel attachment and is determined to be 18 centipoise at 120°C. The formulation is suitable for inkjet application using a conventional inkjet apparatus.

### Example 8

### Inkjettable on Dry Film

A dry film article for soldermask is prepared having a cover sheet which is a 25µ thick sheet of PET, a photoimageable composition forming a layer 50µ thick and a polyethylene protective sheet 25µ thick. The photoimageable composition is formulated as follows:

**Table 8a**

| **Ingredients** | **Wt.%** |
|---|---|
| SCRIPSET 540 (styrene/Maleic Anhydride Co-Polymer | 36.5 |
| MEK | 25.8 |
| Pigment CI 7426 | 1.2 |
| Sterically hindered phenol anti-oxidant | 0.05 |
| Tripropylene glycol diacrylate | 7.54 |
| Tripropylene propane triacrylate | 3.76 |
| Adhesion Promoter of the Thiazole type | 0.33 |
| N-Methylolacrylamide | 2.81 |
| Dimethoxyphenyl Acetophenone | 2.26 |
| Coating aid | 0.56 |
| Methyl Ethyl Ketone | 1.18 |
| Fillers | 18.01 |
| | 100% |

The light-attenuating formulation in the table below is prepared by the same process as the compositions described in Example 1:

**Table 8b**

| **Component** | **Amount Wt.%** |
|---|---|
| Polyethylene glycol (MW = 1305-1595) | 60 |
| Polyethylene-co-polyethylene glycol MW = 875 | 35 |
| Solvent red 135 | 2 |
| 2-chlorothioxanthone | 2 |
| + | |
| 2-methylthioxanthone | |
| Octadecyl-3,5-di-t-butyl-4-hydroxyhydrocinnamate | 1 |

The composition attenuates light from 425nm and below. The viscosity is measured using a Brookfield viscometer with a thermosel attachment and is determined to be 15 centipoise at 120°C. The dry film article is laminated on a copper clad wiring board, and the polyethylene protective sheet is removed to expose the PET cover sheet. The light-attenuating composition of Table 8b is selectively applied to the PET cover sheet to form a pattern on the PET cover sheet. The light-attenuating composition is applied using a piezoelectric drop-on-demand printhead (Spectra Apollo) at 120°C.

The composite of the copper clad wiring board, dry film with PET cover sheet and selectively applied light-attenuating composition is exposed to broadband UV/visible light (xenon mercury lamp). Light at wavelengths of 425nm and below is attenuated at portions of the dry film coated with the light-attenuating composition.

The PET cover sheet with the light-attenuating composition is peeled from the dry film. Developer of 1% sodium carbonate at 30°C is applied to the dry film. Portions masked by the light-attenuating composition are developed away forming a patterned soldermask.

### Example 9

### Inkjettable Composition on Dry Film

The light-attenuating formulation in the table below is prepared by the same process as the compositions described in Example 1:

| **Component** | **Amount Wt.%** |
|---|---|
| Polyethylene glycol (MW = 950-1050) | 57 |
| Polyethylene-co-polyethylene glycol MW = 1750 | 37.5 |
| Solvent red 135 | 2.5 |
| 2-isopropylthioxanthone | 2.5 |
| + | |
| 4-isopropylthioxanthone | |
| Octadecyl-3,5-di-t-butyl-4-hydroxyhydrocinnamate | 0.5 |

The composition attenuates light from 425nm and below. The viscosity is measured using a Brookfield viscometer with a thermosel attachment and is determined to be 18 centipoise at 120°C. The formulation is suitable for inkjet application using a conventional inkjet apparatus. It is selectively applied to the dry film formulation from Example 8 and is used to form a pattern on the dry film as described in Example 8.

### Example 10

### Polyoxyalkylene amine Formulation

The formulation in the table below is prepared by the same process as the compositions described in Example 1:

| **Component** | **Amount Wt.%** |
|---|---|
| JEFFAMINE® M-2070 | 56 |
| JEFFAMINE® D-400 | 37.5 |
| Methine dye | 3 |
| 2-isopropylthioxanthone | 3 |
| + | |
| 4-isopropylthioxanthone | |
| Octadecyl-3,5-di-t-butyl-4-hydroxyhydrocinnamate | 0.5 |

The composition attenuates light from 425nm and below. The viscosity is measured using a Brookfield viscometer with a thermosel attachment and is determined to be 18 centipoise at 120°C. The formulation is suitable for inkjet application using a conventional inkjet apparatus.

## Claims

1. A composition comprising one or more compounds for attenuating light in at least the UV range, and one or more water-soluble or water-dispersible polymers.

2. The composition of claim 1, further comprising one or more antioxidants, one or more organic acids, or mixtures thereof.

3. The composition of claim 1, wherein the one or more light-attenuating compounds is chosen from absorbers, photosensitizers, photoinitiators, dyes, and pigments.

4. The composition of claim 1, wherein the one or more light-attenuating compounds attenuate light at wavelengths of 800nm and below.

5. The composition of claim 1, wherein the one or more water-soluble or water-dispersible polymers enables the composition to be removed from a substrate in one minute or less with water or aqueous base.

6. A composition consisting essentially of one or more compounds for attenuating light in at least the UV range, one or more water-soluble or water-dispersible polymers, one or more antioxidants, and one or more organic acids, the one or more water-soluble or water-dispersible polymers enable the composition to be removed from a substrate in one minute or less with water or aqueous base.

7. A method comprising:
a) depositing a radiant energy sensitive composition or article on a substrate;
b) selectively depositing a masking composition on the radiant energy sensitive composition or article, the masking composition comprises one or more compounds which attenuate light in at least the UV range, and one or more water-soluble or water-dispersible polymers to form a composite;
c) applying actinic radiation to the composite; and
d) applying a developer to the composite to form an image on the substrate.

8. The method of claim 7, wherein the masking composition is deposited on the radiant energy sensitive composition or article by inkjetting.

9. The method of claim 7, wherein the masking composition attenuates light at wavelengths of 800nm and below.

10. The method of claim 7, wherein the viscosity of the masking composition during inkjetting is 25 cps or less.
